# FASCICULE DE BREVET EUROPEEN

(11) **EP 3 084 455 B1**
(45) Date de publication et mention de la délivrance du brevet: **11.10.2023**
(21) Numéro de dépôt: 14808668.9
(22) Date de dépôt: 08.12.2014
(51) Int. Cl.: B60L 3/12, G01R 31/12, H02H 1/00

(54) **DETECTION D'ARCS ELECTRIQUES**
LICHTBOGENDETEKTION
ELECTRIC ARC DETECTION

(30) Priorité: 17.12.2013 FR 1362789
(43) Date de publication de la demande: 26.10.2016
(73) Titulaire: Commissariat à l'Energie Atomique et aux Energies Alternatives, 75015 Paris (FR)
(72) Inventeur: PERICHON, Pierre, 38500 Voiron (FR)
(74) Mandataire: Cabinet Beaumont
(86) Numéro de dépôt international: PCT/EP2014/076922
(87) Numéro de publication internationale: WO 2015/091071

(56) Documents cités:
- WO-A1-97/24742
- ZHAO J ET AL: "Substation monitoring by acoustic emission techniques", IEE PROCEEDINGS: SCIENCE, MEASUREMENT AND TECHNOLOGY, IEE, STEVENAGE, HERTS, GB, vol. 148, no. 1, 5 janvier 2001 (2001-01-05), pages 28-34, XP006016031, ISSN: 1350-2344, DOI: 10.1049/IP-SMT:20010134
- CHENGQIANG WANG ET AL: "The Partial Discharge Locating Experimental Study in Transformer Based on Ultrasonic Phased Array", POWER AND ENERGY ENGINEERING CONFERENCE (APPEEC), 2012 ASIA-PACIFIC, IEEE, 27 mars 2012 (2012-03-27), pages 1-5, XP032240163, DOI: 10.1109/APPEEC.2012.6307654 ISBN: 978-1-4577-0545-8
- Y.H.M YASMIN THAYOOB THAYOOB ET AL: "Detection of acoustic emission signals from partial discharge sources in oil-pressboard insulation system", RESEARCH AND DEVELOPMENT (SCORED), 2010 IEEE STUDENT CONFERENCE ON, 1 janvier 2010 (2010-01-01), pages 381-386, XP055138237, DOI: 10.1109/SCORED.2010.5704027 ISBN: 978-1-42-448647-2

## Description

La présente demande de brevet revendique la priorité de la demande de brevet français FR13/62789.

### Domaine

La présente description concerne de façon générale les systèmes de protection contre des arcs électriques et, plus particulièrement, la détection d'arcs électriques. La présente description s'applique plus particulièrement à la détection d'arcs électriques en milieu fermé.

### Exposé de l'art antérieur

Dans tout système électrique, qu'il s'agisse d'un système de production d'énergie comme par exemple une centrale solaire, d'un système de stockage d'énergie, comme par exemple un ensemble de batteries, d'un système de conversion d'énergie comme par exemple un transformateur, d'un système de transport, comme par exemple un ensemble de câbles, etc., l'apparition d'arcs électriques est particulièrement préjudiciable. Un arc électrique peut provoquer des dommages non seulement au système lui-même, mais peut de plus provoquer des dommages collatéraux importants, comme par exemple provoquer un incendie.

On cherche depuis longtemps à détecter, de manière fiable, l'apparition d'un arc électrique.

On a déjà proposé plusieurs solutions faisant appel soit à une mesure de courant et de tension, soit à une mesure de rayonnement optique, soit à une mesure du champ électromagnétique. Toutes ces méthodes ont pour inconvénients d'être dédiées à une application particulière et de ne pas être transposables à d'autres systèmes.

On a également proposé de détecter des arcs électriques à partir de leur signature acoustique. Ainsi, pour des lignes électriques aériennes, on utilise un capteur acoustique ayant une fréquence de résonance de 40 kHz et un opérateur surveille l'apparition d'un signal audible à l'aide d'écouteurs. Une telle méthode n'est toutefois pas transposable dans un environnement bruité qui constitue la majorité des environnements de systèmes de production, de transport, de consommation d'énergie électrique.

Le document WO-A-2011090464 propose un procédé et un appareil pour détecter des arcs et leur localisation dans un câblage électrique et exploite une plage de fréquences de 28 à 32 kHz.

L'article « Substation Monitoring by Acoustic Emission Techniques » de ZHAO J et al., paru dans IEE Proceedings: Science, Measurement and Technology, vol. 148, n° 1 en Janvier 2001, décrit une technique de détection acoustique d'arcs électriques susceptibles de se produire dans un transformateur. Le capteur de détection acoustique est apposé à l'extérieur du boîtier du transformateur et le boîtier est rempli d'un milieu solide ou liquide et les ondes se propagent à travers le boîtier jusqu'au capteur.

L'article « The Partial Discharge Locating Experimental Study in Transformer Based on Ultrasonic Phased Array » de CHENGQIANG W et al., paru dans Power and Energy Engineering Conférence (APPEEC), 2012 Asie-Pacifique, le 27 mars 2012, décrit également une technique de détection acoustique du type de détection dans un transformateur avec un capteur externe à un boîtier, les ondes se propageant dans un milieu liquide ou solide.

Plus récemment, le demandeur a proposé (WO-A-2013150157) une source d'alimentation électrique continue comportant des batteries interconnectées dans un boîtier, un capteur acoustique et un milieu de remplissage du boîtier présentant une impédance acoustique homogène et servant de liaison acoustique entre les interconnexions des batteries et le capteur. Cette solution préconise l'utilisation d'un capteur à ultrasons avec une bande passante s'étendant au moins entre 20 kHz et 150 kHz.

### Résumé

Un mode de réalisation de la présente description vise à pallier tout ou partie des inconvénients des systèmes connus de détection d'arcs électriques.

Un autre mode de réalisation vise à proposer un système de détection d'arcs électriques plus particulièrement destiné à un environnement bruité.

Ainsi, un mode de réalisation prévoit un procédé de détection d'arcs électriques selon la revendication 1.

Selon un mode de réalisation, ledit premier seuil est déterminé en fonction d'un niveau de bruit capté en l'absence d'arcs électriques.

Selon un mode de réalisation, la mesure prend en compte les fréquences dans une plage d'environ 60 kHz à environ 300 kHz, de préférence dans une plage d'environ 60 kHz à environ 150 kHz.

Selon un mode de réalisation, le procédé comporte en outre une étape de comparaison, à un deuxième seuil, du résultat d'une corrélation entre un modèle de la réponse temporelle d'un arc électrique et la mesure.

Un mode de réalisation prévoit un système de détection d'arcs électriques selon la revendication 5.

Selon un mode de réalisation, le dispositif de mesure est sensible aux fréquences contenues dans une plage d'environ 60 kHz à environ 300 kHz, de préférence dans une plage d'environ 60 kHz à environ 150 kHz.

Selon un mode de réalisation, le dispositif de mesure comporte un capteur acoustique.

Selon un mode de réalisation, la réponse du capteur acoustique exclut les fréquences inférieures à environ 60 kHz.

Selon un mode de réalisation, ledit dispositif comporte un filtre électronique des fréquences inférieures à environ 60 kHz.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 illustre un exemple de réponse spectrale d'un arc électrique ;
la figure 2 illustre un exemple de spectre de bruits ambiants typique, dans l'environnement d'un système électrique ;
la figure 3 représente, de façon très schématique, un mode de réalisation d'un système de détection d'arcs électriques ;
la figure 4 est un schéma-bloc illustrant un mode de mise en oeuvre du procédé de détection d'arcs électriques ; et
la figure 5 représente, de façon très schématique, un exemple d'application du système de la figure 3.

### Description détaillée

De mêmes éléments ont été désignés par de mêmes références aux différentes figures. Par souci de clarté, seuls les éléments utiles à la compréhension des modes de réalisation qui vont être décrits ont été représentés et seront détaillés. En particulier, les dispositifs électriques dont le système détecte les arcs n'ont pas été détaillés, les modes de réalisation décrits étant compatibles avec les divers dispositifs électriques de production, de transport et de consommation. De plus, lorsque l'on fait référence aux expressions "approximativement", "de l'ordre de" ou "environ", cela signifie à 10% près, et lorsque l'on mentionne une identité ou une égalité, cela signifie aux dispersions technologiques près.

Un arc électrique apparaît dans un milieu isolant séparant deux éléments conducteurs à des potentiels électriques différents et dans lesquels circule un courant, une conduction électrique se produisant dans l'espace séparant ces deux éléments conducteurs. L'apparition d'un arc électrique s'accompagne d'une réponse acoustique sonore et ultrasonore.

La méthode de détection d'arcs électriques et les systèmes associés qui vont être décrits tirent leur origine d'une nouvelle analyse faite par l'inventeur du phénomène acoustique accompagnant un arc électrique et de la réponse acoustique des environnements visés. Traditionnellement, les systèmes de détection acoustiques se focalisent soit sur une plage de fréquences large, comme c'est le cas du document WO-A-2013150157, en jouant sur le milieu environnant, soit sur une plage de fréquences inférieure à 40 kHz comme c'est le cas du document WO-A-2011090464.

Les autres techniques connues, basées sur une propagation dans un milieu solide ou liquide et/ou à travers un boîtier vers un capteur externe au boîtier, ne sont pas adaptées à des applications où des vibrations mécaniques sont susceptibles de se produire (un véhicule en mouvement par exemple). En effet, de telles vibrations risquent de provoquer de fausses détections.

Ainsi, dans les modes de réalisation qui vont être décrits, on prévoit une détection acoustique dans un milieu de propagation gazeux, typiquement de l'air, et on utilise des capteurs acoustiques de type microphones détectant des vibrations dans l'air et isolés de vibrations mécaniques de contact avec l'enceinte à l'intérieur de laquelle est(sont) placé(s) le(s) microphone(s).

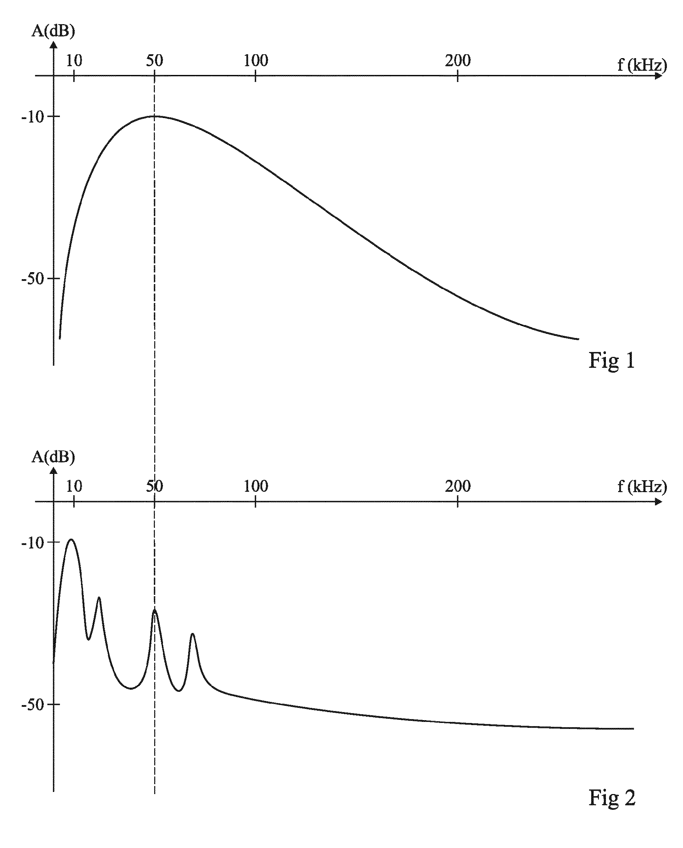

La figure 1 représente, de façon schématique, la réponse acoustique d'un arc électrique dans l'air. L'inventeur a constaté que cette réponse peut varier légèrement en fonction du milieu mais qu'un arc électrique, tout en ayant une réponse présentant un fort niveau entre environ 30 kHz et environ 70 kHz, présente un spectre qui s'étend jusqu'à 150 kHz, voire plus, avec des niveaux non négligeables par rapport au bruit environnant.

L'inventeur a par ailleurs constaté que, contrairement aux idées reçues selon lesquelles les environnements sont fortement bruités par des signaux dans des fréquences supérieures à une quarantaine de kHz, ces niveaux de bruit sont généralement inférieurs aux niveaux d'un arc électrique à ces fréquences.

La figure 2 représente, de façon schématique, le spectre de bruit ambiant d'un environnement représentatif des environnements généralement rencontrés dans des applications où l'on souhaite détecter des arcs électriques. En fait, le bruit ambiant est majoritairement dans le domaine sonore (en dessous de 20 kHz) et, s'il présente quelques pics à des fréquences supérieures (par exemple dus à des commutations de systèmes mécaniques), présente globalement un niveau moyen nettement inférieur à celui d'un arc électrique pour des fréquences supérieures à environ 60 kHz.

Dans les modes de réalisation qui vont être décrits, on prévoit d'utiliser un capteur acoustique (un microphone) dans une enceinte dans laquelle on souhaite détecter l'apparition d'arcs électriques, et de filtrer (éliminer), au niveau du capteur ou de l'électronique associée à ce capteur, les fréquences inférieures à environ 60 kHz.

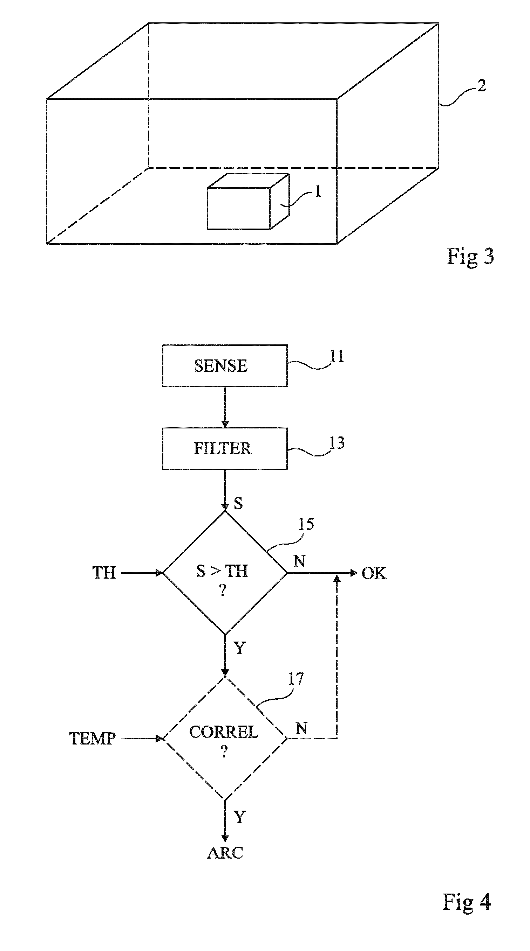

La figure 3 représente, de façon très schématique et sous forme de blocs, un mode de réalisation d'un système de détection d'arcs électriques.

Un capteur acoustique 1 est placé dans une enceinte 2 à l'intérieur de laquelle se situe le volume à surveiller, c'est-à-dire les éléments électriques (non représentés) susceptibles de provoquer un arc électrique. Ce volume n'est pas traité de façon particulière, c'est-à-dire qu'il est, en pratique, le plus souvent constitué d'air ambiant. En variante, le volume intérieur de l'enceinte contient un gaz autre que de l'air.

Les parois de l'enceinte 2 atténuent les bruits venant de l'extérieur. Dans la plage des fréquences sonores et ultrasonores jusqu'à environ 60 kHz, cette atténuation n'est toutefois pas suffisante pour que l'amplitude de l'onde acoustique soit inférieure à celle provoquée par un arc électrique à l'intérieur de l'enceinte. Cependant, pour les fréquences supérieures à environ 60 kHz, le niveau des bruits ambiants extérieurs à l'enceinte est généralement suffisamment faible pour que les parois de l'enceinte provoquent une atténuation suffisante. Ainsi, en filtrant la réponse du capteur acoustique pour éliminer les fréquences inférieures à environ 60 kHz, il est possible de distinguer le bruit ambiant provenant de l'extérieur de l'enceinte, d'un arc électrique se produisant à l'intérieur de l'enceinte.

De plus, le filtrage réalisé permet de s'affranchir également des bruits générés à l'intérieur de l'enceinte dans laquelle se trouve le capteur.

Pour améliorer la détection, on pourra s'assurer que l'enceinte ne présente pas d'ouvertures de façon à améliorer l'atténuation du bruit ambiant (extérieur à l'enceinte). En cas d'ouvertures dans l'enceinte, on veillera préférentiellement à ce que ces ouvertures aient des dimensions inférieures à la longueur d'onde de propagation majoritaire des arcs électriques, par exemple inférieure à quelques mm, de préférence inférieures à 4 mm. Ainsi, on évite que le capteur situé dans l'enceinte ne détecte un arc externe.

Selon le volume à surveiller, on pourra prévoir un cloisonnement de ce volume en plusieurs espaces fermés et plusieurs capteurs acoustiques (au moins un par espace fermé).

La figure 4 est un schéma-bloc d'un mode de mise en oeuvre du procédé de détection d'arcs électriques.

On commence par mesurer (bloc 11, SENSE), à l'aide d'un capteur acoustique, l'amplitude sonore dans le volume considéré. On veillera à ce que le microphone ne soit pas sensible aux vibrations mécaniques, c'est-à-dire qu'il soit conçu pour ne capter que (ou pour capter majoritairement) les ondes sonores propagées par le milieu gazeux et être insensible à des vibrations de son support en contact avec l'enceinte.

Puis (ou simultanément si le capteur lui-même présente une réponse éliminant les fréquences inférieures à environ 60 kHz), on applique un filtrage de type passe-haut (bloc 13, FILTER) qui élimine les fréquences inférieures à environ 60 kHz.

Le signal S résultant est interprété par un circuit électronique et est comparé (bloc 15, S>TH ?) à un seuil TH.

Si le niveau du signal S est supérieur au seuil TH (sortie Y du bloc 15), on considère qu'on est en présence d'un arc électrique (ARC). Selon un premier mode de réalisation, dans le cas contraire (sortie N du bloc 15), on considère une situation normale (OK).

Le seuil TH est, de préférence, fixé en tenant compte des bruits environnants, c'est-à-dire qu'il est choisi pour être supérieur au niveau du signal sonore capté par le capteur 1 dans la plage de fréquences supérieures à environ 60 kHz en l'absence d'arc électrique. De préférence, on tient compte des signaux dans une plage de fréquences allant d'environ 60 kHz à environ 300 kHz, de préférence, dans une plage de fréquences allant d'environ 60 kHz à environ 150 kHz.

De préférence (étape 17 CORREL, illustrée en pointillés en figure 4), la détermination est affinée en comparant, à un deuxième seuil, le résultat d'une corrélation entre un modèle (TEMP) de réponse temporelle d'un arc électrique et la réponse du capteur. Si la réponse du capteur est considérée suffisamment proche du modèle (sortie Y du bloc 17), on valide la présence d'un arc. Par exemple, pour cette deuxième comparaison, on pourra s'inspirer de la technique décrite dans le document WO-A-2013150157 déjà mentionné.

Un exemple d'application concerne les véhicules automobiles et, plus particulièrement, les véhicules électriques contenant un grand nombre de batteries, ce qui accroît les risques d'arcs, en raison des vibrations, de chocs, etc. L'enceinte dans laquelle sont généralement contenues les batteries constitue un filtre suffisant pour que les bruits extérieurs, de fréquence supérieure à environ 60 kHz, soient suffisamment filtrés pour que, à l'intérieur de l'enceinte, un arc électrique se traduise sur le capteur acoustique par un niveau de signal nettement supérieur au bruit.

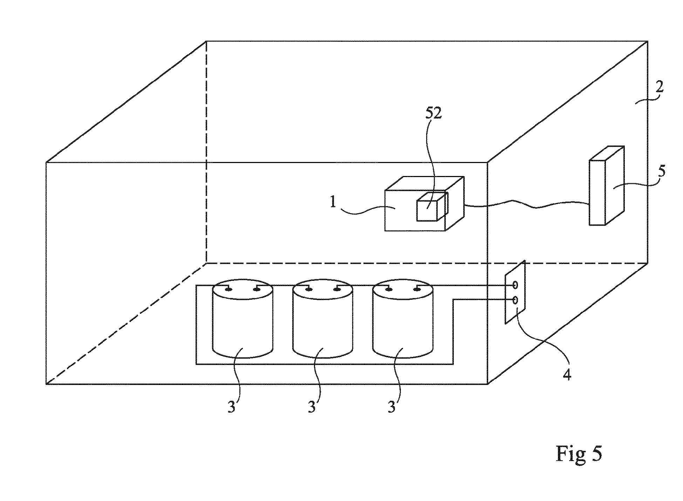

La figure 5 représente, de façon schématique et sous forme de blocs, un mode de réalisation d'un système de détection d'arcs électriques selon cet exemple d'application.

On suppose une enceinte 2 dans laquelle sont disposées et interconnectées des batteries 3. Un connecteur 4 (par exemple, un bornier), accessible depuis l'extérieur de l'enceinte 2, permet de connecter les batteries 3 à leur environnement applicatif. L'enceinte 2 contient également un capteur acoustique 1, relié à un dispositif électronique 5, d'interprétation des signaux captés par le capteur. Le dispositif 5 comporte, par exemple, des éléments de communication de l'état de la détection ou de signalement de la présence d'un arc (alarme visuelle, sonore, ou autre).

Dans l'exemple de la figure 5, on suppose la présence d'un filtre passe-bas 52 (fréquence de coupure à environ 60 kHz), acoustique ou électronique, au niveau du capteur 1. En variante, ce filtre (alors électronique) est au niveau du dispositif 5.

Un autre exemple d'application est la détection d'arcs électriques dans un avion et, plus particulièrement, dans des parties techniques de la carlingue. On a pu constater que la carlingue constituait un obstacle aux bruits ambiants et qu'un arc électrique présentera, dans l'enceinte contenant les câbles électriques, un signal d'amplitude supérieure à ces bruits ambiants, de sorte que la détection peut s'opérer en fixant un seuil approprié. Si le signal mesuré par le capteur (en éliminant les fréquences inférieures à environ 60 kHz) a une amplitude supérieure à ce seuil, on peut considérer un fort risque de présence d'un arc électrique.

Un autre exemple d'application concerne les tableaux électriques destinés à répartir une alimentation électrique dans différents circuits. En particulier dans un milieu industriel, des vibrations peuvent provoquer un desserrement des fixations des câbles aux différents coupe-circuits et connecteurs, qui peut conduire à l'apparition d'arcs électriques. Dans cette application, des arcs électriques non néfastes peuvent se produire dans des interrupteurs ou disjoncteurs situés dans le volume à surveiller, lors des commutations. Les boîtiers de ces interrupteurs ou disjoncteurs atténuent l'amplitude de l'onde acoustique provoquée par ces arcs, de sorte qu'en sélectionnant convenablement le seuil de détection par le capteur, on peut distinguer ces arcs "utiles" d'arcs accidentels se produisant dans le volume surveillé.

Le fait que le boîtier soit fermé et ne laisse pas passer les ondes acoustiques directement de l'air extérieur vers l'air intérieur de l'enceinte entraîne que ces ondes acoustiques du milieu ambiant extérieur à l'enceinte sont largement filtrées et atténuées à l'interface air extérieur/enceinte, puis enceinte/air intérieur.

Par ailleurs, même si des vibrations mécaniques externes (par exemple liées aux vibrations des roues d'un véhicule) qui arrivent jusqu'à l'enceinte sont en partie transmises à l'intérieur de l'enceinte dans le milieu gazeux et constituent des ondes acoustiques, ces ondes sont très atténuées et en partie filtrées (surtout les fréquences supérieures à 60 kHz) à l'interface enceinte/milieu gazeux interne. Ainsi, d'éventuelles vibrations mécaniques ayant pour origine un arc électrique externe sont filtrées et très atténuées par l'interface enceinte/milieu gazeux et les ondes acoustiques internes résiduelles correspondantes, susceptibles d'arriver sur le microphone interne, sont d'amplitude peu importante par rapport à l'amplitude d'ondes acoustiques émises dans le milieu gazeux par des arcs électriques internes.

Un avantage des modes de réalisation qui ont été décrits est qu'il est désormais possible de détecter des arcs électriques dans un environnement acoustiquement bruité.

Un autre avantage est que la mise en oeuvre est simple en tirant profit des enceintes qui entourent généralement les zones dans lesquelles on souhaite effectuer une détection. Il n'est donc généralement pas nécessaire en pratique de prévoir une enceinte spécifique.

Divers modes de réalisation ont été décrits, diverses variantes et modifications apparaîtront à l'homme de l'art. En particulier, les éventuels cloisonnements à prévoir et le nombre de capteurs acoustiques dépendent du volume à surveiller. Par ailleurs, la mise en oeuvre pratique des modes de réalisation décrits est à la portée de l'homme du métier à partir de la description fonctionnelle ci-dessus, en particulier en ce qui concerne la réalisation du dispositif électronique d'interprétation des signaux captés et l'exploitation des résultats de la détection. De plus, le choix des valeurs du ou des seuils de détection dépend de l'application et est également à la portée de l'homme du métier.

## Revendications

1. Procédé de détection d'arcs électriques dans une enceinte (2) fermée, comportant :
une étape (11, 13) de mesure d'un niveau acoustique, capté par un microphone (1) placé à l'intérieur de l'enceinte, à des fréquences supérieures à environ 60 kHz en filtrant les fréquences inférieures ; et
une étape (15) de comparaison dudit niveau à un premier seuil (TH), **caractérisé en ce que**
l'enceinte (2) comporte des ouvertures de dimension inférieure à 5 mm et définit un volume gazeux à surveiller.

2. Procédé selon la revendication 1, dans lequel ledit premier seuil (TH) est déterminé en fonction d'un niveau de bruit capté en l'absence d'arcs électriques.

3. Procédé selon la revendication 1 ou 2, dans lequel la mesure prend en compte les fréquences dans une plage d'environ 60 kHz à environ 300 kHz, de préférence dans une plage d'environ 60 kHz à environ 150 kHz.

4. Procédé selon l'une quelconque des revendications 1 à 3, comportant en outre une étape (17) de comparaison, à un deuxième seuil, du résultat d'une corrélation entre un modèle de la réponse temporelle d'un arc électrique et la mesure.

5. Système de détection d'arcs électriques, comportant :
une enceinte (2) fermée ; et
un dispositif (1, 5) de mesure acoustique filtrant les fréquences inférieures à environ 60 kHz et comportant un microphone placé à l'intérieur de l'enceinte (2),
**caractérisé en ce que**
l'enceinte (2) comporte des ouvertures de dimension inférieure à 5 mm et définit un volume gazeux à surveiller.

6. Système selon la revendication 5, dans lequel le dispositif de mesure (1, 5) est sensible aux fréquences contenues dans une plage d'environ 60 kHz à environ 300 kHz, de préférence dans une plage d'environ 60 kHz à environ 150 kHz.

7. Système selon la revendication 5 ou 6, dans lequel la réponse du microphone (1) exclut les fréquences inférieures à environ 60 kHz.

8. Système selon l'une quelconque des revendications 5 à 7, dans lequel ledit dispositif (1, 5) comporte un filtre électronique (52) des fréquences inférieures à environ 60 kHz.

## Patentansprüche

1. Verfahren zum Erkennen von Lichtbögen in einer geschlossenen Kammer (2), aufweisend:
einen Schritt (11, 13) des Messens eines Schallpegels, der von einem in der Kammer angeordneten Mikrofon (1) erfasst wird, bei Frequenzen, die höher als etwa 60 kHz sind, wobei die niedrigeren Frequenzen herausgefiltert werden; und
einen Schritt (15) des Vergleichs des Pegels mit einem ersten Schwellenwert (TH), **dadurch gekennzeichnet, dass** die Kammer (2) Öffnungen mit einer Größe von weniger als 5 nm aufweist und ein zu überwachendes Gasvolumen definiert.

2. Verfahren nach Anspruch 1, wobei der erste Schwellenwert (TH) anhand eines Geräuschpegels bestimmt wird, der in Abwesenheit von elektrischen Lichtbögen erfasst wird.

3. Verfahren nach Anspruch 1 oder 2, wobei bei der Messung die Frequenzen in einem Bereich von etwa 60 kHz bis etwa 300 kHz, vorzugsweise in einem Bereich von etwa 60 kHz bis etwa 150 kHz, berücksichtigt werden.

4. Verfahren nach einem der Ansprüche 1 bis 3, das ferner einen Schritt (17) aufweist, bei dem das Ergebnis einer Korrelation zwischen einem Modell des Zeitverhaltens eines Lichtbogens und der Messung mit einem zweiten Schwellenwert verglichen wird.

5. Ein System zur Erkennung von Lichtbögen, das Folgendes aufweist:
eine geschlossene Kammer (2); und
eine akustische Messvorrichtung (1, 5), die Frequenzen unterhalb von etwa 60 kHz herausfiltert und ein Mikrofon aufweist, das im Inneren der Kammer (2) angeordnet ist, **dadurch gekennzeichnet, dass** die Kammer (2) Öffnungen mit einer Größe von weniger als 5 nm aufweist und ein zu überwachendes Gasvolumen definiert.

6. System nach Anspruch 5, wobei die Messvorrichtung (1, 5) auf Frequenzen innerhalb eines Bereichs von etwa 60 kHz bis etwa 300 kHz, vorzugsweise innerhalb eines Bereichs von etwa 60 kHz bis etwa 150 kHz, anspricht.

7. Das System nach Anspruch 5 oder 6, wobei der Ansprechverhalten des Mikrofons (1) Frequenzen unter etwa 60 kHz ausschließt.

8. System nach einem der Ansprüche 5 bis 7, wobei die Vorrichtung (1, 5) ein elektronisches Filter (52) für Frequenzen unter etwa 60 kHz aufweist.

## Claims

1. A method of detecting electric arcs in a closed chamber (2), comprising:
a step (11, 13) of measuring a sound level, captured by a microphone (1) placed inside of the chamber, at frequencies higher than approximately 60 kHz while filtering out the lower frequencies; and
a step (15) of comparing said level with a first threshold (TH), **characterized in that** the chamber (2) comprises openings of lower dimension than 5 nm and defines a gas volume to be monitored.

2. The method of claim 1, wherein said first threshold (TH) is determined according to a noise level captured in the absence of electric arcs.

3. The method of claim 1 or 2, wherein the measurement takes into account the frequencies in a range from approximately 60 kHz to approximately 300 kHz, preferably in a range from approximately 60 kHz to approximately 150 kHz.

4. The method of any of claims 1 to 3, further comprising a step (17) of comparing, with a second threshold, the result of a correlation between a model of the time response of an electric arc and the measurement.

5. An electric arc detection system, comprising:
a closed chamber (2); and
an acoustic measurement device (1, 5) filtering out frequencies lower than approximately 60 kHz and comprising a microphone placed inside of the chamber (2), **characterized in that** the chamber (2) comprises openings of lower dimension than 5 mm and defines a gas volume to be monitored.

6. The system of claim 5, wherein the measurement device (1, 5) is sensitive to frequencies contained within a range from approximately 60 kHz to approximately 300 kHz, preferably within a range from approximately 60 kHz to approximately 150 kHz.

7. The system of claim 5 or 6, wherein the response of the microphone (1) excludes frequencies lower than approximately 60 kHz.

8. The system of any of claims 5 to 7, wherein said device (1, 5) comprises an electronic filter (52) of frequencies lower than approximately 60 kHz.
